# EUROPEAN PATENT APPLICATION

(11) **EP 0 664 560 A2**
(43) Date of publication of application: **26.07.1995**
(21) Application number: 95300293.8
(22) Date of filing: 18.01.1995
(51) Int. Cl.: H01L 21/316, C23C 16/40

(54) **Method of forming insulating film**

(30) Priority: 25.01.1994 JP 6381/94
(71) Applicant: CANON SALES CO., INC., Minato-ku, Tokyo (JP); ALCAN-TECH CO., INC., Tokyo 108 (JP); SEMICONDUCTOR PROCESS LABORATORY CO., LTD., Minato-ku, Tokyo 108 (JP)
(72) Inventor: Maeda, Kazuo, c/o Semicond. Proc. Lab. Co. Ltd., Tokyo (JP); Tokumasu, Noboru, c/o Semicond. Proc. Lab. Co. Ltd, Tokyo (JP); Yuyama, Yoshiaki, c/o Semicond. Proc. Lab. Co. Ltd, Tokyo (JP)
(74) Representative: Maury, Richard Philip

(57) **Abstract**

The present invention relates to a film forming method of forming a silicon containing insulating film by a plasma CVD method. Objects of the present invention are to form, using high safety reaction gas, an insulating film which has dense quality, has excellent step coverage, includes a small amount of moisture and contained organic residue such as carbon, and can fit to the silicon oxide film formed by the thermal CVD method, and also to control the refractive index and stress etc. of the insulating film to be formed. The mixed gas including the organic compound having Si-H bonds and the oxdizing gas is plasmanized to react, and the silicon containing insulating film 15 is formed on the depositing substrate 14.

## Description

### BACKGROUND OF THE INVENTION

### 1. Field of the Invention

The present invention relates to a method of forming a silicon containing insulating film by the plasma CVD method.

### 2. Description of the Prior Art

Conventionally, the silicon containing insulating film formed by the plasma CVD method has, in general, merits that quality of the insulating film is dense so that a moisture permeability can be lowered, and a contained amount of moisture in the insulating film can be made to be small.

Thus this insulating film has often been used as a covering film for an insulating film which has a considerably large moisture permeability although it has good step coverage.

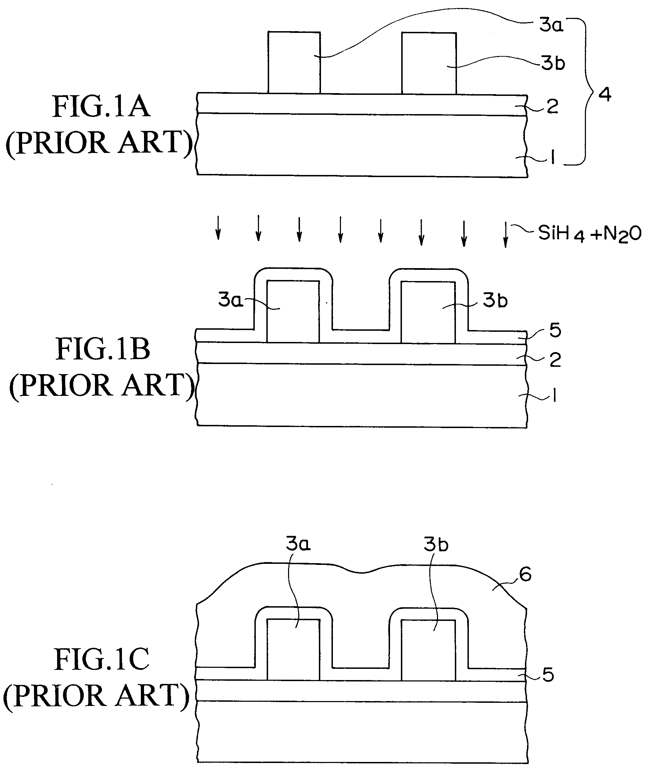

A conventional method of forming the silicon containing insulating film by the plasma CVD method will be described hereinafter. FIGS.1A to 1D are cross sectional views showing a method of forming an interlayer insulating film having a three layered structure, which is formed by sandwiching the silicon oxide film formed by the thermal CVD method between the silicon containing insulating films formed by the plasma CVD method. In this case, a parallel plate type plasma CVD apparatus is used as the plasma CVD apparatus.

FIG.1A is a cross sectional view showing a structure obtained after interconnection layers are formed and before the silicon containing insulating film is formed by the plasma CVD method.

In FIG.1A, a numeral 1 denotes a silicon substrate; 2, backing insulating film on the silicon substrate 1; and 3a and 3b, interconnection layers formed on the backing insulating film 2, djacent to each other and spaced at a predetermined distance. These layers etc. constitute a depositing substrate 4.

Under this state, as shown in FIG.1B, first the depositing substrate 4 is placed under reduced pressure, then a reaction gas composed of a mixed gas of SiH₄ +N₂ O is introduced into the space over the depositing substrate 4, and then the reaction gas is made into plasma by high frequency electric power (RF electric power). The N₂O gas is dissociated into an activating nitrogen N* and an activating oxygen O* by the plasmanization to react to SiH₄ so that the silicon containing insulating film 5 made of an SiOₓ N_{y} film is formed so as to cover the interconnection layers 3a, 3b. By adjusting x and y in the above SiOₓN_{y} film 5 through controlling conditions, a refractive index and an etching speed, both closely relate to denseness of the insulating film etc., can be controlled, and also film stress and the like can be adjusted. For instance, the refractive index can be controlled within a range 1.45 to 2.0 and can therefore be adjusted as the case required.

Then, as shown in FIG.1C, a silicon oxide film (referred to as NSG film hereinafter) 6 is formed on the silicon containing insulating film 5 by the thermal CVD method using a mixed gas of TEOS+O₃.

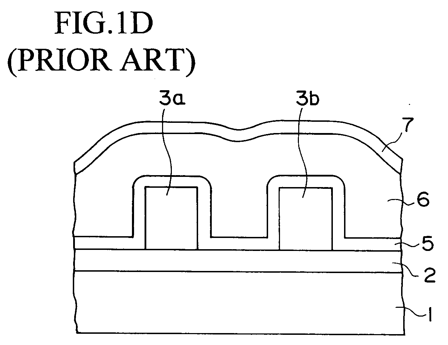

Next, as shown in FIG.1D, the reaction gas composed of the mixed gas of SiH₄ +N₂ O is plasmanized to be reacted in the same manner as used in FIG.1B. Consequently, the silicon containing insulating film 7 made of SiOₓN_{y} film is formed on the silicon oxide film 6.

While, since the SiOₓ N_{y} films 5, 7 formed as described above have inferior step coverage, they are not suitable for the cases where they are used to bury the recess between the narrowly spaced interconnection layers 3a, 3b or where they are formed on the depositing substrate 4 having the uneven surface in the case of having formed the interconnection layers 3a, 3b on the backing insulating film 2. The SiH₄ gas itself is well known as highly dangerous gas.

Instead of the mixed gas of SiH₄ +N₂ O, the mixed gas of SiH₄ +O₂ may be considered as the reaction gas including SiH₄. However, the mixed gas of SiH₄ +O₂ is not suitable to be used in the plasma CVD method since it has strong reaction in gas phase.

In order to avoid the above drawback, in recent, the reaction gas including TEOS has often been used instead of the reaction gas including SiH₄ in the plasma CVD method. For example, in case the reaction gas of TEOS/O₂ system is used, various merits can be obtained, unlike the reaction gas of SiH₄ +O₂, such that the SiO₂ film (silicon containing insulating film) can be formed under any conditions, high safety can be warranted, and excellent step coverage of the formed insulating film can be achieved.

However, since the organic compound is used as the reaction gas, there are many drawbacks such that the formed SiO₂ film contains carbon, it also includes moisture considerably, and it has a high moisture permeability.

Although the SiO₂ film can always be formed under any conditions, it is hard to control the refractive index and the film stress of the insulating film. Thus the insulating film formed using the reaction gas including above TEOS lacks the flexibility in practical applications. For instance, the refractive index is always about 1.45.

Furthermore, in case, as shown in FIG.1D, the interlayer insulating film having the three layered structure, which is formed by sandwiching the silicon oxide film formed by the thermal CVD method between the silicon containing insulating films by the plasma CVD method, is formed, the silicon containing insulating film formed by the TEOS/O₂ system gas is less fit to the silicon oxide film formed as the interlayer film by using the mixed gas of TEOS+O₃ than the silicon containing insulating films 5, 7 formed by using the reaction gas of SiH₄+N₂O was.

Namely, when the silicon oxide film formed by the thermal CVD method is formed on the silicon containing insulating film formed by the reaction gas of the TEOS/O₂ system, a rate of forming the film is lower than that of forming the silicon oxide film directly on the silicon substrate, and therefore unevenness in thickness occurs. Thus, anomalous growth of the silicon oxide film by the thermal CVD method is caused readily.

In addition, when a silicon oxide film is formed by the thermal CVD method on the silicon containing insulating film by the reaction gas of TEOS/O₂, the step coverage of the silicon oxide film becomes degraded. As a result, voids are often formed in the recess between the interconnection layers etc. which are covered by such silicon containing insulating film.

### SUMMARY OF THE INVENTION

An object of the present invention is to provide a method of forming a film by means of the plasma CVD method using a reaction gas of high safety, the method being capable of forming the film which has dense quality, includes a small amount of moisture and contained organic residue such as carbon, has excellent step coverage, and can fit to the silicon oxide film formed by the thermal CVD method, and being capable of controlling the refractive index and stress etc. of the formed insulating film.

In the present invention, the mixed gas including the organic compound having Si-H bonds and the oxdizing gas is used as the reaction gas in the plasma CVD method.

The organic compound having Si-H bonds such as alkylsilane or allylsilane, alkoxysilane, chain siloxane or ring siloxane has not so strong reaction as SiH4, and thus has high safety. The organic compound is in the liquid state at normal temperature and thus is easy to handle.

The Si-H bonds included in the reaction gas serve to absorb oxygen generated in the plasma decomposition or gas such as O₂ and N₂O in the oxidizing gas and to bring out them to the exterior of the system. As a result, the formed insulating film becomes short of oxygen. Under this condition, since Si is contained excessively in the insulating film, the quality of the insulating film is dense. Thus the refractive index can be varied according to an amount of Si. By bringing the insulating film into Si-excessive condition, fitness of the insulating film for the silicon oxide film formed by the thermal CVD method using the mixed gas of TEOS+O₃ can be improved.

Furthermore, in case the gas including nitrogen is used as the oxidizing gas, the refractive index and stress etc. of the formed insulating film can be controlled by adjusting an amount of nitrogen contained in the formed insulating film.

Also, according to the experiment, the insulating film formed by the plasma CVD method using the above reaction gas has contained a small amount of moisture and organic residue such as carbon, and has had good step coverage.

The following are raised as the organic compound having Si-H bonds which can achieve above advantages, for example:
1. Alkylsilane or allylsilane: RₙSiH₄₋ₙ (n=1 to 3)
2. Alkoxysilane: (RO)ₙSiH₄₋ₙ (n=1 to 3)
3. Chain siloxane: Rₙ H₃₋ₙ SiO(Rₖ H₂₋ₖ SiO)ₘ SiH₃₋ₙ Rₙ (n=1, 2; k=0 to 2; m≧0)
4. Ring siloxane: (RₖH₂₋ₖSiO)ₘ (k=1; m≧2) Where a symbol R denotes alkyl group, allyl group or their derivative in each general formula.

Gases in the following, which are suitable to be combined with above organic compounds, can be used as the oxidizing gas. That is, O₂ or N₂O is mainly used for the organic compound listed in the above item 1, and N₂O is mainly used for the organic compound listed in the above items 2 to 4.

As the oxidizing gas, there are NO₂, CO, CO₂, H₂O and the like, in addition to these O₂ and N₂O. The above organic compound can be used by being combined suitably with at least one among these gases. There are 83 combinations of 6 kinds of the oxidizing gas, and any one of these above organic compounds can be combined with one of these combinations.

As described above, the method of forming the film by the plasma CVD method according to the present invention leads to forming, using high safety reaction gas, a silicon containing insulating film such that has dense quality, includes a small amount of moisture and contained organic residue such as carbon, has excellent step coverage, and can fit to the silicon oxide film formed by the thermal CVD method, and to controlling the refractive index etc. of the silicon containing insulating film.

### BRIEF DESCRIPTION OF THE DRAWINGS

FIGS.1A to 1D are cross sectional views showing the method of forming the film according to the conventional example;
FIGS.2A to 2D are cross sectional views showing a method of forming the film according to the first embodiment of the present invention;
FIG.3 is a side view showing a structure of the plasma CVD apparatus used in the method of forming the film according to the embodiment of the present invention;
FIG.4 is a characteristic view illustrating a research result whether or not moisture is included in the silicon containing insulating film formed by the method of forming the film according to the embodiment of the present invention;
FIG.5 is a characteristic view illustrating a research result how the refractive index of the silicon containing insulating film formed by the method of forming the film according to the embodiment of the present invention depends upon a flow amount of N2O;
FIG.6 is a characteristic view illustrating a research result how the film forming rate of the silicon containing insulating film formed by the method of forming the film according to the embodiment of the present invention depends upon the refractive index;
FIG.7A is a cross sectional view showing a sectional shape of SiOxNy film formed by the plasma CVD method using the mixed gas of SiH₄ +N₂O according to the first comparison example;
FIG.7B is a cross sectional view showing a sectional shape of the silicon oxide film formed by the plasma CVD method using the mixed gas of SiH₄ +N₂O according to the second comparison example;
FIG.8A is a cross sectional view showing a sectional shape of the silicon oxide film formed by the thermal CVD method using the mixed gas of TEOS+O₃ on the SiOₓN_{y} film shown in FIG.7A according to the first comparison example;
FIG.8B is a cross sectional view showing a sectional shape of the silicon oxide film formed by the thermal CVD method using the mixed gas of TEOS+O₃ on the SiOₓN_{y} film shown in FIG.7B according to the second comparison example;
FIG.9 is a characteristic view illustrating how the refractive index and the film forming rate of the silicon containing insulating film according to the first comparison example depends upon a ratio of flow amount of N₂O/flow amount of SiH₄ containing gas flow; and
FIG.10 is a characteristic view illustrating how the refractive index and the film forming rate of the silicon containing insulating film according to the second comparison example depends upon a ratio of flow amount of O₂/flow amount of TEOS containing gas.

### DESCRIPTION OF THE PREFERRED EMBODIMENTS

Next, methods of forming a film by a plasma CVD method according to embodiments of the present invention will be described with reference to Figures hereinafter.

### (1) Explanation of the reaction gas used in the method of forming the film by the plasma CVD method according to the embodiment of the present invention:

(i) Concrete embodiment of the organic compound having Si-H bonds;
(A) Alkylsilane or allylsilane: Rₙ SiH₄₋ₙ (n=1 to 3) Where a symbol R denotes alkyl group, allyl group or their derivative in general formulae. The alkyl group is expressed by the general formula Cₙ H₂ₙ₊₁, the allyl group denotes a generic term of the residue obtained by removing one hydrogen atom from the nucleus of aromatic hydrocarbon. A phenyl group C₆H₅- is derived from benzene, a tolyl group CH₃C₆H₄- is derived from toluene, a xyllel group (CH₃)₂C₆H₃- is derived from xylene, and a naphthyl group C₁₀H₄- is derived from naphthalene. Also, the derivatives are organic compounds generated by changes in small portions in molecules of the organic compounds.
It is preferable that the range of n of the alkyl group CₙH₂ₙ₊₁ is below 5. In particular, it is optimum in respect of vapor pressure that n is 1 or 2.
A preferred embodiment of the alkylsilane is shown in Table 1.

**Table 1**

| molecular formula | boiling point(°C) | melting point(°C) |
|---|---|---|
| (CH₃)₂SiH(C₂H₅) | 46 | - |

Preferred embodiments of derivatives of the alkylsilane are shown in Table 2.

**Table 2**

| molecular formula | boiling point(°C) | melting point(°C) |
|---|---|---|
| CH₃SiH(Cl)₂ | 41 - 42 | -93 |
| (CH₃)₂SiH(Cl) | 36 | -111 |
| CH₃SiH(C₂H₅)Cl | 67 - 68 | - |
| (C₂H₅)₂SiH(Cl) | 143(1.3) | -157 |

A preferred embodiment of the allylsilane is shown in Table 3.

**Table 3**

| molecular formula | boiling point(°C) | melting point(°C) |
|---|---|---|
| C₆H₅SiH₃ | 120 | - |
| (C₆H₅)₂SiH₂ | 100 - 101(4) | - |
| (C₆H₅)₃SiH | 160 - 165(0.4) | 42.44 |
| CH₃(C₆H₅)SiH₂ | 139 | - |

Preferred embodiments of derivatives of the allylsilane are shown in Table 4.

**Table 4**

| molecular formula | boiling point(°C) | melting point(°C) |
|---|---|---|
| (C₆H₅)₂SiH(Cl) | 143(1.3) | - |
| C₆H₅SiH(CH₃)Cl | 113(13) | 1.054 |

(B) Alkoxysilane: (RO)ₙSiH₄₋ₙ (n=1-3)
Where a symbol R denotes alkyl group, allyl group or their derivative in general formulae.
Preferred embodiments of alkoxysilane are shown in the following.
① Trimethoxysilane: (CH₃O)₃SiH
The trimethoxysilane is a colorless, transparent liquid having the molecular weight 122.2 and the boiling point 86!n. It has an inflammability, but it does not have explosive and hypergolic property like SiH₄. Thus it can be handled in the same manner as TEOS.
The trimethoxysilane has a following constitutional formula. 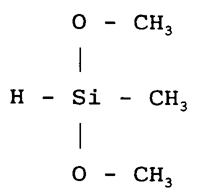
② Triethoxysilane: (C₂H₅O)₃ SiH
The triethoxysilane has the boiling point 131.5°C and the melting point -170°C, and has a following constitutional formula. 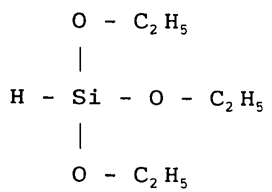
Preferred embodiments of alkoxysilane and its derivatives including the above are summarized in the following Table 5.

**Table 5**

| molecular formula | boiling point(°C) | melting point(°C) |
|---|---|---|
| (CH₃O)₃SiH | 86 - 87 | - |
| (C₂H₅O)₃SiH | 131.5 | -170 |

(C) Chain siloxane: Rₙ H₃₋ₙSiO(RₖH₂₋ₖSiO)ₘ SiH₃₋ₙRₙ (n=1, 2; k=0-2; m≧0)
Where a symbol R denotes alkyl group, allyl group or their derivative in general formulae.
(a) Disiloxane: Rₙ H₃₋ₙSiOSiH₃₋ₙRₙ (n=1, 2)
   Disiloxane correspond to the case where m= O in the general formula of the chain siloxane. There is a derivative of the disiloxane expressed by the general formula (RO)ₙ H₃₋ₙSiOSiH₃₋ₙ(OR)ₙ (n=1, 2). The symbol R in general formulae denotes alkyl group or allyl group.
   Preferred embodiments of the disiloxane are shown in the following.
   ① Tetramethyldisiloxane: (CH₃)₂HSiOSiH(CH₃)₂
      The tetramethyldisiloxane has the boiling point 70 - 71°C, and has a following constitutional formula. 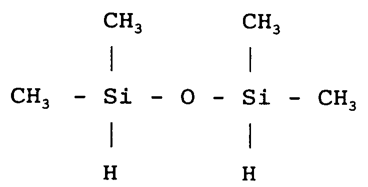
   ② Tetraethyldisiloxane: (C₂H₅)₂ HSiOSiH(C₂H₅)₂
      The tetraethyldisiloxane has a following constitutional formula. 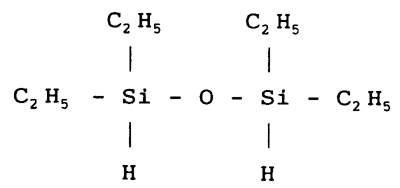
      Preferred embodiments of the derivatives of the disiloxane are shown in the following, and have the following constitutional formulae. 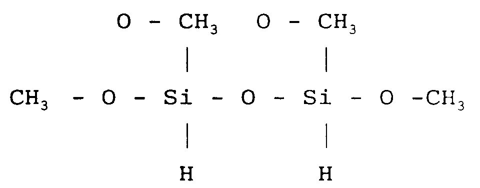 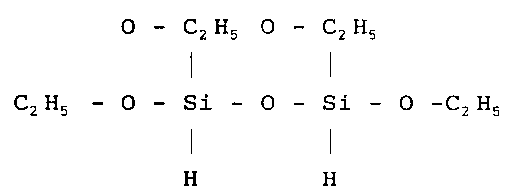
(b) Chain siloxane: RₙH₃₋ₙSiO(RₖH₂₋ₖSiO)ₘSiH₃₋ₙ Rₙ (n=1, 2; k= 0-2; m≧1)
   Preferred embodiments of the chain siloxane except for the disiloxane are shown in the following.
   ① Trimethyltrisiloxane: (CH₃)H₂SiO((CH₃)HSiO)SiH₂(CH₃)
      The trimethyltrisiloxane has a following constitutional formula. 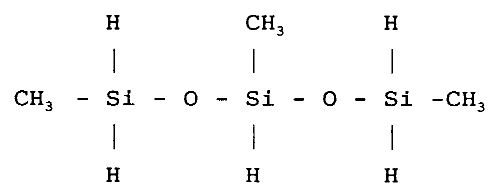
   ② Pentamethyltrisiloxane: (CH₃)₂ HSiO((CH₃ )HSiO)SiH(CH₃ )₂
      The pentamethyltrisiloxane has a following constitutional formula. 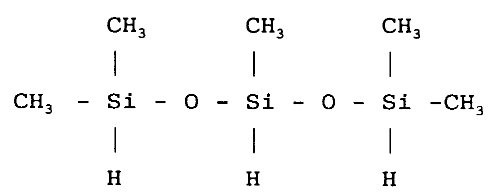
   ③Triethyltrisiloxane : (C₂ H₅ )H₂ SiO((C₂ H₅ )HSiO)SiH₂ (C₂ H₅ )
      The triethyltrisiloxane has a following constitutional formula. 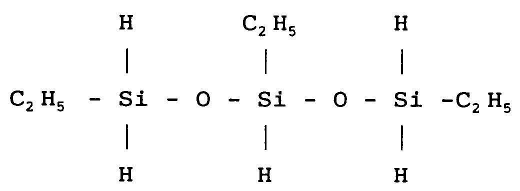
   ④Pentaethyltrisiloxane :(C₂H₅)H₂SiO((C₂H₅)HSiO)SiH₂(C₂H₅)₂
      The pentaethyltrisiloxane has a following constitutional formula.

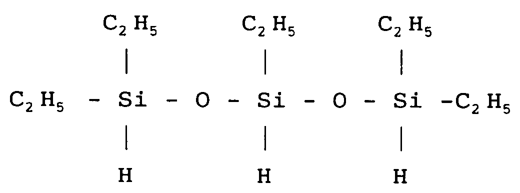

(D) Ring siloxane: (RₖH₂₋ₖSiO)ₘ (k=1; m≧2)
Where a symbol R in general formulae denotes alkyl group, allyl group or their derivative.
Preferred embodiments of the ring siloxane are shown in the following.
① TMCTS: ((CH₃ )HSiO)₄
   The TMCTS has the boiling point 134 - 135°C and the melting point -69°C, and has a following constitutional formula. 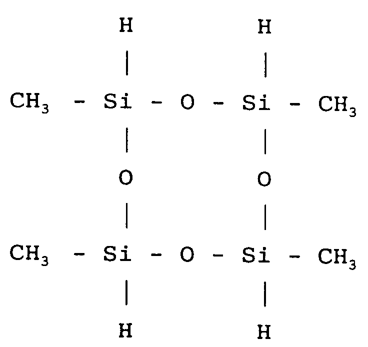
② TECTS: ((C₂H₅)HSiO)₄
   The TECTS has a following constitutional formula. 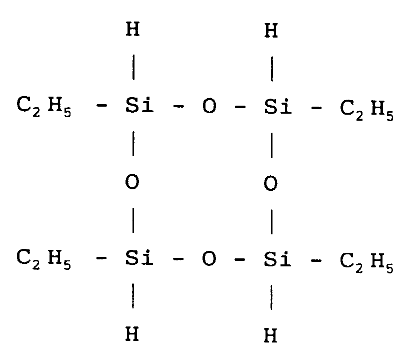
   Organic compounds having Si-H bonds, that is, alkylsilane, allylsilane, alkoxysilane or siloxane, as described above, do not have so strong reaction as SiH and have high safety. They are mainly in liquid at normal temperature so that they are easy to handle.

(ii) Concrete examples of the reaction gases obtained by combining each of the above organic compounds with the oxidizing gas:
Examples of the reaction gases which are obtained by combining each of the above organic compounds with the oxidizing gas are given in the following.
(A) Reaction gases obtained by adding O₂ or N₂O to the organic compounds recited in the above (i)(A).
(B) Reaction gases obtained by adding N₂O to the organic compounds recited in the above (i)(B).
(C) Reaction gases obtained by adding N₂O to the organic compounds recited in the above (i)(C).
(D) Reaction gases obtained by adding N₂O to the organic compounds recited in the above (i)(D).

As the oxidizing gas, NO₂, CO, CO₂ and H₂O can be used, in addition to O₂ and N₂O. At least one of these oxidizing gases can be utilized by being combined with one of the organic compounds recited in the above (i)(A) to (D). Reaction gases of 83 type can be realized as the combination of six kinds of the reaction gases. One of these reaction gases can be combined with either one of the above organic compounds.

### (2) Explanation of examples applied to the semiconductor apparatus:

### (i) Explanation of the plasma CVD apparatus

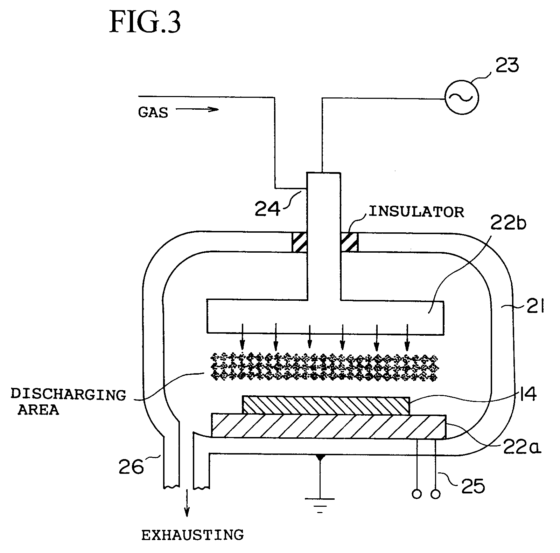

FIG.3 is a side view showing a structure of the parallel plate type plasma CVD apparatus used in the method of forming the insulating film according to the embodiment of the present invention.

In FIG.3, a numeral 21 denotes a chamber, and numerals 22a, 22b denote a pair of electrodes formed so as to oppose to each other. When the high frequency electric power (RF electric power) is applied to the electrodes 22a, 22b, the reaction gas introduced into the space between the electrodes 22a, 22b is plasmanized.

The electrode 22a to be grounded also serves as a placing table of the depositing substrate 14.

While, the electrode 22b, to which the high frequency power supply (RF power supply) is connected, also serves as a shower head for supplying the reaction gas. The reaction gas is introduced from a gas inlet 24 connected to the shower head 22b.

The electrode 22a has a built-in heater (not shown) for heating the depositing substrate 14, and a power supply is connected to the power supplying interconnections 25 for the heater.

A numeral 26 is an exhaust port to which an exhausting apparatus (not shown) is connected so as to exhaust used gas and the unnecessary reaction gas and to keep the interior of the chamber 21 at a predetermined pressure.

### (ii) Explanation of the method of forming the film according to the embodiment of the present invention

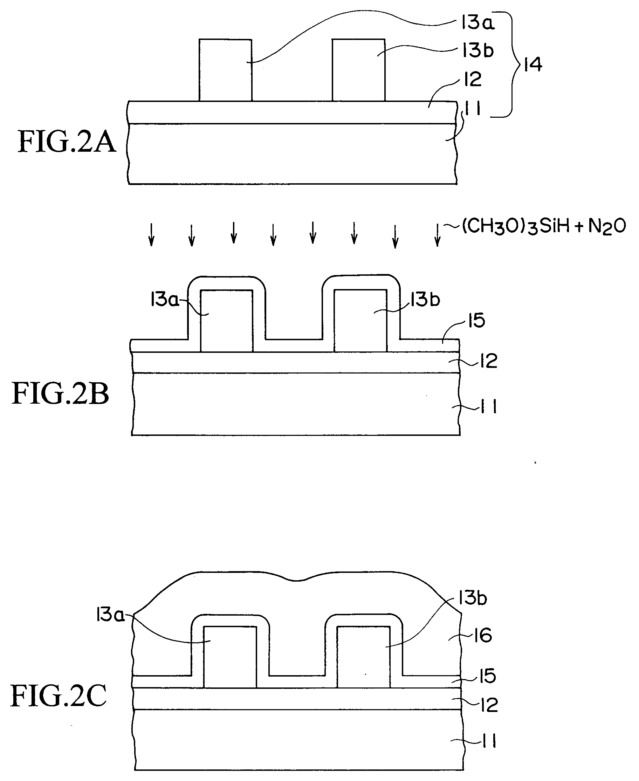

FIGS.2A to 2D are cross sectional views showing the method of forming the film by the plasma CVD method according to the first embodiment of the present invention.

Assuming that the parallel plate type plasma CVD apparatus is used as the plasma CVD apparatus and thattrimethoxysilane (CH₃O)₃SiH among the alkoxysilane is used as the reaction gas, the explanation will be made in the following.

FIG.2A is a cross sectional view showing a structure obtained after the interconnection layers are formed and before the silicon containing insulating film is formed by the plasma CVD method. In FIG.2A, a numeral 11 denotes the silicon substrate; 12, backing insulating film made of the silicon oxide film formed on the silicon substrate 11; and 13a, 13b, interconnection layers formed on the backing insulating film 12 adjacent to each other and spaced at a predetermined distance. These constitute the depositing substrate 14.

Under this condition, first the depositing substrate 14 is placed on the electrode 22a in the chamber 21, and then the pressure of the interior of the chamber 21 is reduced. The depositing substrate 14 is then heated by the heating apparatus and is held within a temperature range 300 to 400°C.

Next, liquid trimethoxysilane held at a temperature 10°C is subject to a bubbling using argon gas (carrier gas) of a flow amount of 100 SCCM so that argon gas including trimethoxysilane is generated. A predetermined flow amount of N₂O gas is added as the oxidizing gas to the resultant argon gas, and then the mixed gas is introduced into the chamber 21 from the gas inlet. At this time, the pressure in the chamber 21 is held at about 1 Torr. In order to try experiments, the flow amount of N₂O gas will be varied variously.

Then, the high frequency electric power having the frequency 13.56 MHz or 100 kHz and the power 400 W is supplied to the electrodes 22a, 22b. As a result, the reaction gas between the electrodes 22a, 22b is plasmanized.

N₂ O is dissociated into the activation nitrogen N* and the activation oxygen O* by plasmanization, and they react to Si-H. Then, as shown in FIG.2B, SiOₓ N_{y} film (silicon containing insulating film) 15 is formed to cover the interconnection layers 13a, 13b.

The Si-H bonds included in the reaction gas serve to absorb oxygen generated in the plasma decomposition or gas such as O₂ and N₂O in the oxidizing gas and to bring out them to the exterior of the system. As a result, the formed SiOₓN_{y} film 15 becomes short of oxygen. Under this condition, since Si is contained excessively in the SiOₓ N_{y} film 15, the quality of the SiOₓ N_{y} film 15 is dense. Thus the refractive index can be varied according to an amount of Si. By bringing the insulating film into Si-excessive condition, fitness of the insulating film for the silicon oxide film formed the thermal CVD method by using the mixed gas of TEOS+O₃ can be improved.

Furthermore, in case the gas including nitrogen is used as the oxidizing gas, the refractive index and stress etc. of the formed SiOₓ N_{y} film 15 can be controlled by adjusting an amount of nitrogen contained in the formed SiOₓ N_{y} film 15.

Like the insulating film formed by the plasma CVD method using the mixed gas of TEOS+O₂, the SiOₓ N_{y} film 15 has also good step coverage.

Consequently, as shown in FIG.2C, the silicon oxide film 16 is formed on the SiOₓN_{y} film 15 by the thermal CVD method. In particular, the depositing substrate 14 is placed in the normal pressure atmosphere. While the temperature of the substrate 14 is kept at about 400 °C, the reaction gas, which is obtained by adding O₃+O₂ gas including O₃ at a concentration rate of 6 % into TEOS carried by the carrier gas, is introduced. The reaction gas is decomposed thermally to be reacted so as to form a silicon oxide film 16 on the SiOₓN_{y} film 15. Since the backing SiOₓN_{y} film 15 is enoughly fit to the silicon oxide film 16 formed by the thermal CVD method using the mixed gas of TEOS+O₃, a rate of forming the silicon oxide film 16 is uniform. As a result, the abnormal growth of the silicon oxide film 16 can be suppressed, and the silicon oxide film 16 has good step coverage.

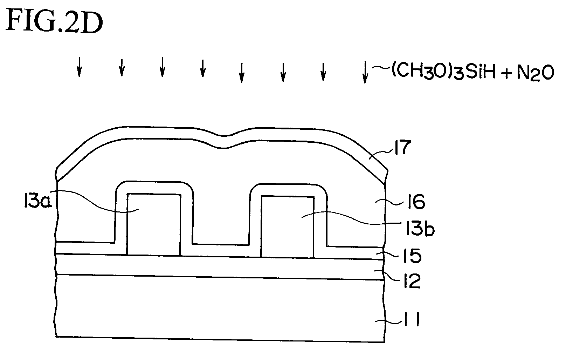

Thereafter, as shown in FIG.2D, SiOₓ N_{y} film (silicon containing insulating film) 17 is formed on the silicon oxide film 16 by the plasma CVD method under the same condition as the above. Thus an interlayer insulating film having a three layered structure can be formed.

Subsequently, film forming rate, refractive index, contained amount of moisture and stress of the formed SiOxNy films 15, 17 was examined and the results will be described.

The silicon containing insulating films (SiOₓN_{y} films) 15, 17 was formed under the following conditions.
Reaction gas: (CH₃O)₃SiH(Ar)+N₂O
Gas pressure: 1 Torr
Temperature of substrate : 400 °C
RF frequency: 13.56 MHz
RF electric power: 400 W
Refractive index: 1.493

Also the silicon oxide film 16 was formed under the following conditions.
Reaction gas: TEOS(N₂)+O₃/O₂ (O₃ concentration is 6%)
Gas pressure: normal pressure
Temperature of substrate: 400 °C

### [Film forming rate]

800 - 1500 Å/min

### [Stress]

According to the result of the stress measurement, the film formed by the applied electric power of the frequency 13.56 MHz has the stress of 5 - 10×10⁸ dyne/cm² (tensile stress), and the film formed by the applied electric power of the frequency 100 kHz has the stress of 5 - 10×10⁸ dyne/cm² (compressive stress).

It is noted that, according to the frequency of the applied electric power used to plasmanize the reaction gas, the kind of stress is changed. It can be seen that the quality of the film having the compressive stress is dense.

From the above result, it is preferable that the appliedfrequency of the electric power used to plasmanize the reaction gas is 100 kHz.

### [Contained amount of moisture]

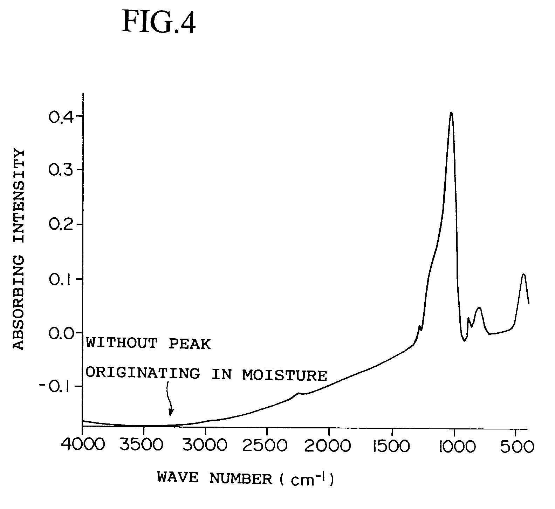

FIG.4 is a view showing the result of contained amount of moisture in the SiOₓN_{y} films 15, 17 examined by the infrared absorption spectrum method.

In FIG.4, the axis of ordinate denotes the absorption strength shown in proportional scale, and the axis of abscissa denotes the number of wave (cm⁻¹) shown in proportional scale.

According to the result, no peak indicating moisture appears. Thus, it is noted that the contained amount of moisture in the SiOₓN_{y} films 15, 17 is extremely small.

### [Refractive index]

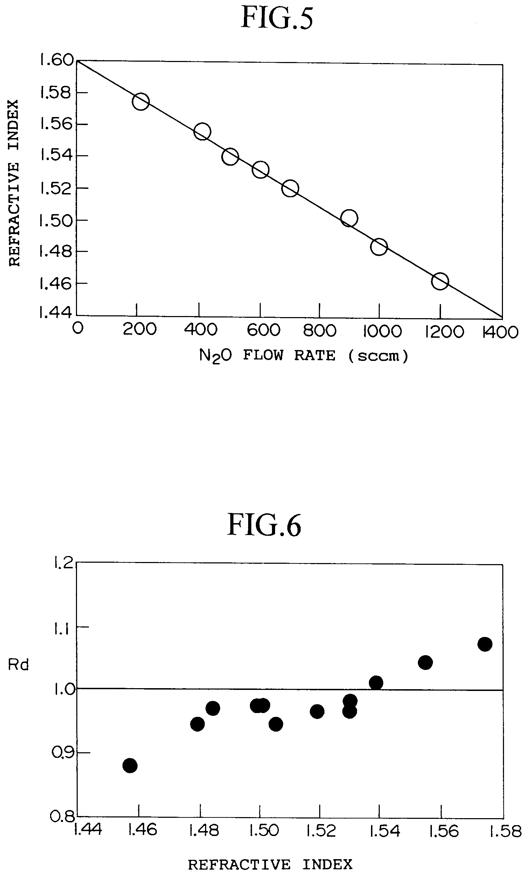

FIG.5 is a view showing the dependency of the refractive index of the SiOₓN_{y} films 15, 17 upon the flow amount of N₂O containing gas. The magnitude of the refractive index is used as a criterion for evaluating the denseness of the film, and is also used as a criterion for evaluating the fitness to the silicon oxide film by the thermal CVD method.

In FIG.5, the axis of ordinate denotes the refractive index shown in proportional scale, and the axis of abscissa denotes the flow amount of N₂O containing gas (SCCM) shown in proportional scale.

It can be seen from the result that the refractive index was changed inversely proportional to the flow amount of N₂O containing gas and that the refractive index was changed within almost 1.58 to 1.46 according to the flow amount 200 to 1200 SCCM. Thus the refractive index can be controlled by adjusting the flow amount of N₂O containing gas. The higher the refractive index becomes, the denser the quality of the film becomes. As described hereinbelow, the fitness to the silicon oxide film 16 formed by the thermal CVD method becomes good.

### [Fitness to silicon oxide film formed by thermal CVD method]

FIG.6 is a view showing the dependency of the film forming rate of the silicon oxide film formed by the thermal CVD method upon the refractive index. By evaluating a ratio of the film forming rate (Rd) of the silicon oxide film 16 formed by the thermal CVD method when it is formed on the SiOₓ N_{y} film 15 by the plasma CVD method to the film forming rate of the silicon oxide film formed by the thermal CVD method when it is formed directly on the silicon substrate, the fitness of SiOₓ N_{y} film 15 formed by the plasma CVD method to the silicon oxide film 16 formed by the thermal CVD method can also be evaluated. It can be seen that, when Rd becomes close to 1, good fitness can be obtained.

In FIG.6, the axis of ordinate denotes the ratio of the film forming rate (Rd) shown in proportional scale, and the axis of abscissa denotes the refractive index shown in proportional scale. According to the result, the ratio of the film forming rate was about 0.9 at about 1.46 of the refractive index, the ratio of the film forming rate was about 1 within a range about 1.48 to 1.56 of the refractive index, and the ratio of the film forming rate closed to 1.1 at 1.58 of the refractive index. It can be suggested by this fact that, in contrast to the SiO₂ film obtained by using the mixed gas of TEOS+O₂, the fitness can be extremely improved and is as high as the SiOxNy film obtained by using the mixed gas of SiH₄+N₂O.

As described above, according to the embodiments of the present invention, the Si-H bonds included in the reaction gas serve to absorb oxygen generated in the plasma decomposition or gas such as O₂ and N₂O in the oxidizing gas and to bring out them to the exterior of the system. As a result, the formed silicon containing insulating films 15, 17 become short of oxygen. Under this condition, since Si atoms are contained excessively in the silicon containing insulating films 15, 17, the quality of the silicon containing insulating films 15, 17 becomes dense. Thus the refractive index can be varied according to an amount of Si atoms. By bringing the insulating film into Si-excessive condition, fitness of the insulating film to the silicon oxide film 16 formed by the thermal CVD method using the mixed gas of TEOS+O₃ can be improved.

Furthermore, in case the gas including nitrogen is used as the oxidizing gas, the refractive index and the stress etc. of the formed SiOₓ N_{y} film 15 can be controlled by adjusting an amount of nitrogen contained in the formed silicon containing insulating films 15, 17.

The silicon containing insulating films 15, 17 formed by the plasma CVD method using the above reaction gas have small contained amount of organic compounds such as moisture, carbon etc., and have good step coverage.

With the above, in the method of forming the film by the plasma CVD method according to the present invention, using high safety reaction gas, the silicon containing insulating films 15, 17, which have dense film quality and have small contained amount of organic residues such as moisture, carbon etc., and have good step coverage, can be formed. The refractive index and the like of the formed silicon containing insulating films 15, 17 can also be controlled.

### (B) Second embodiment

In the method of forming the film by the plasma CVD method according to the second embodiment, an interlayer insulating film having the same three layered structure as that of the first embodiment is formed using triethoxysilane (C₂H₅O)₃SiH as the reaction gas.

The silicon containing insulating films (SiOₓ N_{y} films) were formed under the following conditions.
Reaction gas: (C₂H₅O)₃ SiH(Ar)+N₂O
Gas pressure: 1 Torr
Temperature of substrate : 400 °C
RF frequency: 13.56 MHz
RF electric power: 400 W
Refractive index: 1.493

Also the silicon oxide film was formed under the following conditions.
Reaction gas: TEOS(N₂)+O₃/O₂ (O₃ concentration is 6%)
Gas pressure: normal pressure
Temperature of substrate: 400 °C

In the second embodiment, like the first embodiment, using high safety reaction gas, the silicon containing insulating films which have dense film quality and have small contained amount of organic residues such as moisture, carbon etc., and have good step coverage can be formed. The refractive index and the like of the formed silicon containing insulating films can also be controlled.

### (C) Third embodiment

In the method of forming the film by the plasma CVD method according to the third embodiment of the present invention, an interlayer insulating film having the same structure as that of the first embodiment is formed using tetramethyldisiloxane (CH₃)₂HSiOSiH(CH₃)₂ as the reaction gas.

The silicon containing insulating films (SiOₓ N_{y} films) were formed under the following conditions. Other conditions are identical to those conditions described above.
Reaction gas: (CH₃)₂ HSiOSiH(CH₃)₂(Ar)+N₂O
Gas pressure: 1 Torr
Temperature of substrate : 400 °C
RF frequency: 13.56 MHz
RF electric power: 400 W
Refractive index: 1.493

Also the silicon oxide film was formed under the following conditions. Other conditions are identical to those conditions described above.
Reaction gas: TEOS(N₂)+O₃/O₂ (O₃ concentration is 6%)
Gas pressure: normal pressure
Temperature of substrate: 400 °C

In the third embodiment, like the first embodiment, using high safety reaction gas, the silicon containing insulating films which have dense film quality and have small contained amount of organic residues such as moisture, carbon etc., and have good step coverage can be formed. The refractive index and the like of the formed silicon containing insulating films can also be controlled.

### (iii) Comparison examples

### (A) First comparison example

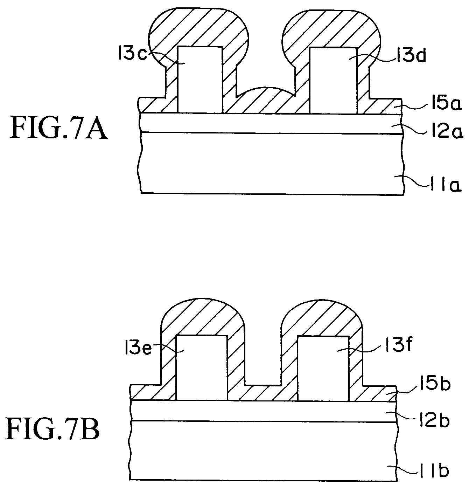

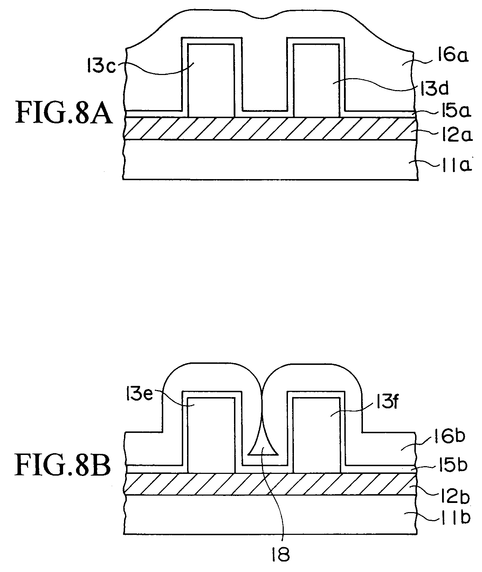

FIG.7A is a cross sectional view showing the structure obtained after SiOₓN_{y} film 15a is formed by the plasma CVD method using the mixed gas of SiH₄+N₂O according to the first comparison example. The sectional shape of the SiOₓ N_{y} film 15a is illustrated with emphasis. FIG.8A shows a sectional shape obtained when the silicon oxide film 16a is formed on the SiOₓN_{y} film 15a formed by the thermal CVD method using the mixed gas of TEOS+O₃.

The silicon containing insulating film (SiOₓN_{y} film) was formed under the following conditions.
Reaction gas: mixed gas of SiH₄ + N₂O
Gas pressure: 1 Torr
Temperature of substrate : 400 °C
RF frequency: 13.56 MHz
RF electric power: 400 W
Refractive index: 1.493

Also the silicon oxide film 16a was formed under the following conditions.
Reaction gas: TEOS(N₂)+O₃/O₂ (O₃ concentration is 6%)
Gas pressure: normal pressure
Temperature of substrate: 400 °C

As shown in FIG.7A, the sectional shape of the silicon containing insulating film 15a does not become a flow shape, but it becomes a mushroom shape since the insulating film 15a deposits thickly on the upper sidewalls of the interconnection layers 13c, 13d. Accordingly, voids are ready to occur in the reccess between the interconnection layers 13c, 13d as the interconnection layers 13c, 13d becomes narrow.

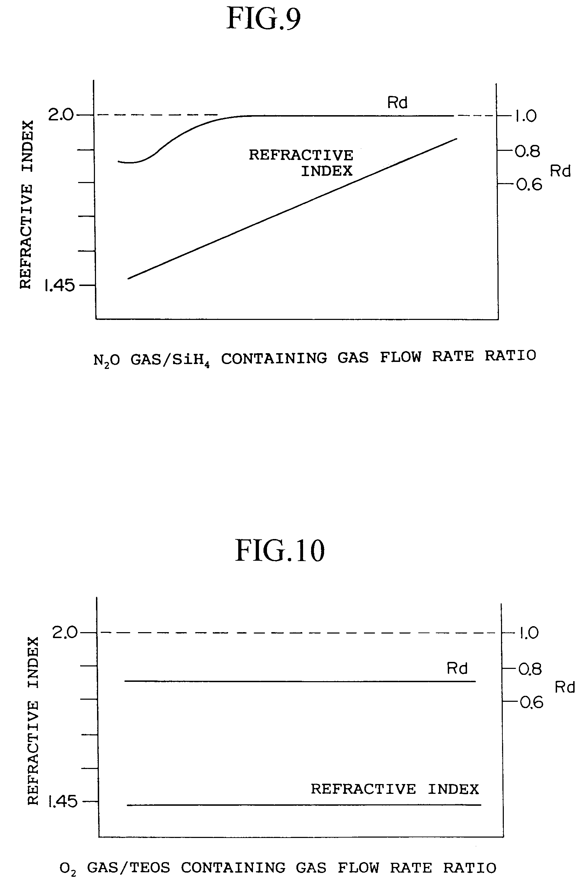

FIG.9 is a view showing a dependency of the refractive index and the ratio of the film forming rate (Rd) upon the flow amount of N₂O containing gas.

In FIG.9, the axis of left side ordinate denotes the refractive index in proportional scale and the axis of right side ordinate denotes the ratio of the film forming rate in proportional scale, and the axis of abscissa denotes a ratio of flow amount of N₂O gas/flow amount of SiH4 containing gas in proportional scale.

As can be seen from the result, the rate of the film forming rate is almost 0.8 and the fitness to the silicon oxide film 16a by the thermal CVD method using the mixed gas of TEOS+O₃ is low if the ratio of flow amount of N₂O gas/flow amount of SiH₄ containing gas is small, but the rate of the film forming rate becomes almost 1 and the fitness to the silicon oxide film 16a becomes high if the ratio of flow amount is large. As a result, as shown in FIG.8A, the silicon oxide film 16a has a flow shape, and the step coverage can be improved.

### (B)Second comparison example

FIG.7B is a cross sectional view of a structure obtained after the silicon oxide film (SiO₂ film) 15b is formed by the plasma CVD method using the mixed gas of TEOS+O₂ according to the second comparison example. Especially, the sectional shape of the silicon oxide film 15b is illustrated with emphasis.

In addition, FIG.8B is a cross sectional view showing a structure obtained after the silicon oxide film 16b is formed on the silicon oxide film 15b by means of the thermal CVD method using the mixed gas of TEOS+O₃. Especially, the sectional shape of the silicon oxide film 16b is illustrated with emphasis.

The silicon oxide film (SiO₂ film) 15b was formed under the following conditions.
Reaction gas: mixed gas of TEOS+O₂
Gas pressure: 1 Torr
Temperature of substrate : 400 °C
RF frequency: 13.56 MHz
RF electric power: 400 W
Refractive index: 1.493

Also the silicon oxide film 16b was formed under the following conditions.
Reaction gas: TEOS(N₂)+O₃/O₂ (O₃ concentration is 6%)
Gas pressure: normal pressure
Temperature of substrate: 400 °C

As shown in FIG.7B, a sectional shape of the silicon oxide film 15b does not become the flow shape as in the case where the mixed gas of SiH₄+N₂O is used. But, unlike the case where the mixed gas of SiH₄+N₂O is used, the silicon oxide film 15b has the same thickness on both the side walls of the interconnection layers 13e, 13f and the backing insulating film 12b, and therefore the abnormal growth cannot found. Consequently, even if the interconnection layers 13e, 13f become narrow, voids are hard to occur in the recess between the interconnection layers 13e, 13f.

FIG.10 is a view showing a dependency of the refractive index and the ratio of the film forming rate (Rd) upon the the ratio of flow amount of O₂ gas/flow amount of TEOS containing gas.

In FIG.10, the axis of left side ordinate denotes the refractive index in proportional scale, the axis of right side ordinate denotes the ratio of film forming rate in proportional scale, and the axis of abscissa denotes the ratio of flow amount of O₂ gas/flow amount of TEOS containing gas in proportional scale.

According to the result, it is noted that, irrespective of the ratio of flow amount of O₂ gas/flow amount of SiH4 containing gas, the rate of the film forming rate is almost 0.8 which is considerably smaller than 1, and that the fitness to the silicon oxide film 16b formed by the thermal CVD method using the mixed gas of TEOS+O₃ is low.

Therefore, as shown in FIG.8B, when the silicon oxide film 16b is formed by the thermal CVD method using the mixed gas of TEOS+O₃ on the silicon oxide film 15b which covers the interconnection layers 13e, 13f, the silicon oxide film 16b does not become the flow shape and therefore the voids are ready to occur in the recess between the interconnection layers 13e, 13f. On the contrary, in the case shown in FIG.2C according to the embodiment of the present invention, the silicon oxide film 16 has the flow shape, and has excellent step coverage.

By summarizing the above results into Table 6, the characteristic of the silicon containing insulating film 15 or 17 according to the first embodiment can be compared with the characteristics of the silicon containing insulating films 15a according to the above first comparison example and the silicon oxide film 15b according to the second comparison example, and the like.

**Table 6**

| | first embodiment | first comparison | second comparison |
|---|---|---|---|
| density of film(denseness) | high | high | low |
| film quality on side wall | good(same as on plane) | good | unstable |
| refractive index | variable | variable | invariable (constant) |
| carbon impurity | nothing or a little | nothing | much |
| moisture | a little | extremely little | much |
| moisture permeability | a little | a little | much |
| step coverage | good | bad | good |
| stress | stable | stable (no change with time) | unstable (change with time) |
| fitness to TEOS/O3 APCVD NSG | good | good | unstable |
| (surface dependency) | (Rd=1.0) | (Rd=0.7-1.0) | (Rd=0.7-0.8) |
| safety | high | low | high |

## Claims

1. A method of forming an insulating film comprising the steps of:
plasmanizing mixed gas including an organic compound having Si-H bonds and oxdizing gas;
reacting said organic compound with said oxdizing gas; and
forming a silicon containing insulating film (15) on a dipositing substrate (14).

2. The method of forming an insulating film according to claim 1, wherein said organic compound having Si-H bonds is made of one selected from the group consisting of alkylsilane, allylsilane, alkoxysilane and siloxane.

3. The method of forming an insulating film according to claim 2, wherein one of said alkylsilane and allylsilane is expressed by a general formula Rₙ SiH₄₋ₙ (n=1 to 3), and said R denotes one selected from the group consisting of alkyl group, allyl group and their derivative.

4. The method of forming an insulating film according to claim 2, wherein said alkoxysilane is expressed by a general formula (RO)ₙSiH₄₋ₙ (n=1 to 3), and said R denotes one selected from the group consisting of alkyl group, allyl group and their derivative.

5. The method of forming an insulating film according to claim 2, wherein said siloxane is chain siloxane expressed by a general formula RₙH₃₋ₙSiO(RₖH₂₋ₖ SiO)ₘ SiH₃₋ₙ Rₙ (n=1, 2; k=0 to 2; m≧0), and said R denotes one selected from the group consisting of alkyl group, allyl group and their derivative.

6. The method of forming an insulating film according to claim 5, wherein said siloxane is derivative of said chain siloxane expressed by a general formula (RO)ₙ H₃₋ₙ SiOSiH₃₋ₙ (OR)ₙ (n=1, 2), and said R denotes one selected from the group consisting of alkyl group and allyl group.

7. The method of forming an insulating film according to claim 2, wherein said siloxane is ring siloxane expressed by a general formula (RₖH₂₋ₖ SiO)ₘ (k=1; m≧2), and said R denotes one selected from the group consisting of alkyl group, allyl group and their derivative.

8. The method of forming an insulating film according to claim 1, wherein said oxidizing gas includes at least one selected from the group consisting of O₂, NO, N₂O, NO₂, CO, CO₂ and H₂O gases.
